# EUROPÄISCHE PATENTSCHRIFT

(11) **EP 0 793 903 B1**
(45) Veröffentlichungstag und Bekanntmachung des Hinweises auf die Patenterteilung: **25.03.1998**
(21) Anmeldenummer: 96931814.6
(22) Anmeldetag: 18.09.1996
(51) Int. Cl.: H05K 3/02, B23K 26/00

(54) **BESCHICHTUNG ZUR STRUKTURIERTEN ERZEUGUNG VON LEITERBAHNEN AUF DER OBERFLÄCHE VON ELEKTRISCH ISOLIERENDEN SUBSTRATEN**
COATING FOR THE STRUCTURED PRODUCTION OF CONDUCTORS ON THE SURFACE OF ELECTRICALLY INSULATING SUBSTRATES
REVETEMENT POUR LA PRODUCTION STRUCTUREE DE CHEMINS CONDUCTEURS A LA SURFACE DE SUBSTRATS ELECTRIQUEMENT ISOLANTS

(30) Priorität: 21.09.1995 DE 19535068
(43) Veröffentlichungstag der Anmeldung: 10.09.1997
(73) Patentinhaber: LPKF CAD/CAM SYSTEME GMBH, D-30827 Garbsen (DE)
(72) Erfinder: KICKELHAIN, Jörg, D-31535 Neustadt (DE); VITT, Bruno, D-52808 Aachen (DE)
(74) Vertreter: Braun, Dieter, Dipl.-Ing.
(86) Internationale Anmeldenummer: EP9604074
(87) Internationale Veröffentlichungsnummer: WO9711589

(56) Entgegenhaltungen:
- EP-A- 0 280 362
- APPLIED PHYSICS LETTERS, Bd. 59, Nr. 6, 5.August 1991, NEW YORK US, Seiten 647-649, XP000233632 J. G. LUNNEY ET AL.: "Excimer laser etching of transparent conducting oxides"
- PATENT ABSTRACTS OF JAPAN vol. 17, no. 621 (P-1645), 16.November 1993 & JP,A,05 196949 (SEMICONDUCTOR ENERGY LAB CO), 6.August 1993,
- PATENT ABSTRACTS OF JAPAN vol. 10, no. 138 (M-480), 21.Mai 1986 & JP,A,60 260393 (HANDOUTAI ENERUGII KENKYOSHO KK), 23.Dezember 1985,

## Beschreibung

Die Erfindung betrifft eine Beschichtung zur strukturierten Erzeugung von Leiterbahnen mittels Laser-Strahlung auf der Oberfläche von elektrisch isolierenden Substraten, insbesondere zur Herstellung von Sensorelementen und Leiterplatten, wobei die Beschichtung von einer dotierten Zinnoxid; Schicht mit der Zusammensetzung Sn_{1-(y+z}) A_{y} B_{z} O₂ mit A = Sb oder F und B = In oder Al gebildet ist, sowie ein Verfahren zum Aufbringen der Beschichtung sowie ein Verfahren zur Weiterverarbeitung der Beschichtung zu strukturierten Leiterbahnen. Eine derartige Beschichtung ist aus der EP 0 280 362 A2 bekannt.

Im Chip- und Waferbereich für Mikrosensoren, für Hybridschaltungen, Displays, etc., kommt der strukturierten Erzeugung von Leiterbahnen eine zentrale Rolle zu. In diesen Bereichen werden sogenannte Master (Masken) zur Strukturierung eingesetzt, welche in der Regel aus Glasmaterial als Trägerwerkstoff bestehen. Auf diesen Werkstoff wird eine dünne homogene oder inhomogene Schicht, in der Regel Chrom, aufgedampft, welche dann mit dem entsprechend geforderten Layout strukturiert werden muß. Auch in vielen anderen Bereichen der Elektronik ist die Strukturierung von dünnen Schichten oder Verbunden auf vornehmlich Glassubstraten in Hinblick auf eine Verwendung als Leiter- und Verdrahtungssystem sehr interessant. Hier ist es bereits bekannt, eine zu strukturierende dünne Metallschicht von ca. 0,1 µm bis 0,2 µm Stärke mit einem Lack zu beschichten, der dann mittels eines Elektronen- oder Laserstrahls bzw. über optische Systeme belichtet und entwickelt wird. Dann erfolgt ein chemischer Ätzschritt, welcher die freigelegten metallischen Flächen beseitigt.

Im Bereich der Herstellung von Leiterplatten ist es durch die DE 40 10 244 A1 bereits bekannt geworden, auf eine Leiterplatte einen Leitlack aufzutragen und dann aus dem Leitlack das Leiterbild mit Hilfe eines Lasers herauszuarbeiten. Das so erzeugte Leiterbild wird anschließend metallisiert.

Aus der eingangs genannten EP 0 280 362 A2 ist auch bereits die Verwendung vollflächiger Zinnoxid-Beschichtungen für Dünnschicht-Heizelemente bekannt. Hier ist auch bereits eine zweifache Dotierung von Zinnoxid mit Antimon oder Fluor einerseits und Indium oder Aluminium andererseits beschrieben, wodurch der Einsatz derartiger Schichten bei höheren Temperaturen bei Dünnschicht-Heizelementen ermöglicht werden soll. Es ist bekannt, daß Zinnoxid-Schichten besonders bei höheren Temperaturen mit der Atmosphäre (O₂, H₂O) in Wechselwirkung treten, was zu erheblichen Veränderungen ihrer elektrischen Leitfähigkeit führen kann. Um derartige Schichten auch bei hohen Temperaturen als elektrisch stabile, transparente Dünnschicht-Heizelemente verwenden zu können, wird Antimon und Indium äquimolar, also in gleicher Menge, dotiert. Es wird hier insbesondere darauf hingewiesen, daß diese Mengen um nicht mehr als 10 % voneinander abweichen dürfen. Die Schichten weisen zudem ein Antimon- und Indium-Gehalt von jeweils 3 bis 5 Atom-% auf. Dabei werden durch das Antimon die Leitfähigkeit gesteigert und durch das Indium die Kristalldefekte stabilisiert.

Der Erfindung liegt die Aufgabe zugrunde, eine auf Glas- oder Keramik-Substrate aufbringbare dünne und elektrisch leitfähige Beschichtung zu schaffen, in die Isolationskanäle hochauflösend und rückstandsfrei mittels Laser-Strahlung im Wellenlängenbereich von 157 nm bis 308 nm direkt strukturiert werden können. Außerdem sollen Verfahren zur Herstellung einer derartigen Beschichtung und zu deren Weiterverarbeitung angegeben werden.

Diese Aufgabe wird erfindungsgemäß durch die Merkmale des Anspruchs 1 bzw. des Anspruchs 5 sowie des Anspruchs 7 gelöst. Die weitere Ausgestaltung der Erfindung ist den Unteransprüchen zu entnehmen.

Dadurch, daß der Gehalt der Beschichtung an den Dotierstoffen Antimon oder Fluor zu Indium oder Aluminium durch die Grenzen 0,02 < y + z < 0,11 gegeben ist und das Verhältnis der Dotierstoffe der Bedingung 1,4 < y/z < 2,2 genügt, wird überraschenderweise erreicht, daß derartige Schichten durch Abtrag mittels elektromagnetischer Laser-Strahlung im Wellenlängenbereich von 157 nm bis 308 nm hochauflösend und rückstandsfrei mit Isolationskanälen strukturierbar sind. Ferner wird die Aufgabe durch ein Verfahren gelöst, das dadurch gekennzeichnet ist, daß die Beschichtung auf ein elektrisch isolierendes Substrat aus Glas, Keramik oder einem Halbleitersilizium bei einer Oberflächentemperatur von 400 °C bis 600 °C mittels eines Aerosol-Sprühpyrolyse-Verfahrens bei einer Temperatur von 400 °C bis 600 °C in einer Dicke zwischen 50 nm und 500 nm aufgetragen wird.

Die durch Abtrag mittels elektromagnetischer Laser-Strahlung im Wellenlängenbereich von 157 nm bis 308 nm hergestellten, feinen leitfähigen Strukturen zeichnen sich durch senkrechte scharfkantige Wände der Isolationskanäle aus, und die Schicht besitzt eine außergewöhnlich gute Beständigkeit gegenüber chemischen Medien sowie mechanischen und thermischen Belastungen. Die erfindungsgemäßen Beschichtungen können Anwendung finden für Sen-soren, z. B. für Feuchte-Sensoren für Pkw-Frontscheiben, sowie für Leiterbahnen von mikroelektronischen Schaltungen, hier insbesondere für Hochfrequenz-Bauelemente auf Quarzglas-Substrat, und z. B. in Kombination mit LCD-Schichten als Displays. Die hohe Leitfähigkeit und gleichzeitig hohe Korrosionsbeständigkeit werden erzielt durch die speziellen Parameter des Beschichtungs- und des Strukturierungs-Prozesses, sowie insbesondere durch die Zugabe von Antimon (Sb) und Indium (In) in den angegebenen Konzentrationen zum Zinnoxid. Alternativ können unter Beibehaltung der angegebenen Konzentrationen für Antimon auch Fluor, und für Indium auch Aluminium eingesetzt werden.

Als besonders vorteilhaft hat es sich erwiesen, wenn die Schicht die Zusammensetzung Sn_{0,919}Sb_{0,052}In_{0,029}O₂ aufweist. Wie sich gezeigt hat, weist insbesondere eine derartige Schicht eine optimale elektrische Leitfähigkeit auf und ist außerdem mittels eines Excimerlasers hochauflösend, rückstandsfrei und äußerst scharfkantig abtragbar. Eine derartige Schicht ist auf die Oberfläche eines Glassubstrates aufgebracht, nahezu metallisch leitfähig und transparent und weist zudem eine außergewöhnlich hohe Korrosionsbeständigkeit und mechanische Festigkeit auf.

Vorzugsweise wird die Beschichtung bei Temperaturen von 400 °C bis 600 °C mittels eines Aerosol-Sprühpyrolyse-Verfahrens aufgetragen. Die Dicke der Beschichtung liegt zwischen 50 nm und 500 nm. Die anschließende Strukturierung der Schicht wird gemäß einer bevorzugten Ausführungsform der Erfindung durch Abtrag mittels eines Krypton-Fluorid-Excimerlasers mit einer Wellenlänge von 248 nm vorgenommen.

In weiterer Ausgestaltung der Erfindung ist es vorgesehen, daß das Substrat aus Quarzglas, Glaskeramik, Hartglas, insbesondere Borosilikat-Hartglas, Weichglas, Keramik, insbesondere Aluminiumoxid-Keramik oder Halbleitersilizium besteht.

Es ist durch den Einsatz der erfindungsgemäßen Beschichtung möglich geworden, Zinnoxid als Halbleiter mit einer Energiebandlücke von 3,6 eV und somit transparent für sichtbares Licht, als feinststrukturierbare Schicht für z. B. Sensoren zu nutzen. Dabei wird der an sich bekannte Effekt benutzt, daß durch die Zugabe von geeigneten Dotierstoffen in Zinnoxid eine für Halbleiter ungewöhnlich hohe Dichte frei beweglicher Elektronen (bis nahezu 10²¹ pro cm³) erzeugt werden kann. Wird derart dotiertes Zinnoxid in Form dünner Schichten auf Glassubstraten abgeschieden, so erhalten diese elektrisch isolierenden Gläser einen nahezu metallisch leitfähigen und gleichzeitig durchsichtigen Überzug.

Erfindungsgemäß wurde gefunden, daß Zinnoxid-Schichten mit einem Gehalt von vorzugsweise 5,2 mol % Antimon und von 2,9 mol % Indium sich problemlos und exakt mittels Excimerlaser strukturieren lassen und auch danach elektrochemisch und mechanisch stabil sind. Wie sich gezeigt hat, bereiten andererseits z. B. äquimolar mit Antimon und Indium dotierte Schichten hinsichtlich der Strukturierung mittels eines Excimerlasers Schwierigkeiten. Im übrigen sind die elektrische Leitfähigkeit und die mechanische Haftfähigkeit der nunmehr erfindungsgemäß eingesetzten Schichten im Vergleich zu den Schichten gemäß dem Stand der Technik in vorteilhafter Weise höher.

Es ist durchaus überraschend, daß es möglich ist, die erfindungsgemäß eingesetzte Beschichtung mittels eines Excimerlasers fein strukturiert abzutragen. Speziell bei Metallen erschien bisher u. a. wegen der hohen Bindungsenergie ein wirtschaftlicher Einsatz von Excimerlasern zum rückstandsfreien Abtrag nicht möglich. Betrachtet man die Wechselwirkungsmechanismen von Laserstrahlung und Materie, so regen die Laserwellenlängen vornehmlich Schwingungsmoden innerhalb der Materie an und erwärmen somit z. B. Metalle bis zum flüssigen bzw. gasförmigen Aggregatzustand. Letztlich ergibt sich ein thermisches Abtragsverfahren, das für eine hochauflösende Strukturierung, insbesondere auch aufgrund hier unvermeidbarer Metallablagerungen, nicht geeignet ist. Der Bereich der wirtschaftlichen Nutzung des Excimerlasers lag daher bisher ausschließlich innerhalb des Bereiches der Ablation von Polymeren. Hier sind erhebliche Vorteile beim Abtrag erreichbar, die aus den hohen Photonenenergien dieser Laserstrahlung resultieren. Anders als bei thermisch wirkender Laserstrahlung wird bei Polymeren die Bindungsenergie der Moleküle aufgehoben und Partikel und Monomere kalt abgespalten. Es handelt sich hier um einen nichtthermischen Abtragsprozeß.

Die Vorteile eines Einsatzes von Excimerlasern waren aus den genannten Gründen im Bereich von dotierten Metalloxiden keineswegs zu erwarten. Insbesondere war auch der erfolgreiche Einsatz eines Excimerlasers zum Abtragen der erfindungsgemäß eingesetzten ZinnoxidSchichten nicht zu erwarten. Immerhin hatten Versuche der Anmelderin zur Herstellung eines Feuchte-Sensors, in ihren Eigenschaften ähnliche Schichten, wie z. B. ChromnitridSchichten, direkt zu strukturieren, keinen Erfolg. Es hat sich vielmehr gezeigt, daß es hier beim Einsatz eines Excimerlasers, aufgrund der Verdampfung von Material, innerhalb der abgetragenen Bereiche zu Niederschlägen kam. Ein funktionsfähiger Sensor war aus diesem Grunde bisher mittels eines Laser-gestützten Materialabtrags nicht herstellbar.

Wie sich jedoch überraschenderweise gezeigt hat, ist ein gepulster Excimerlaser für einen wirtschaftlichen Direktabtrag einer nunmehr entwickelten speziellen Beschichtung mit der erfindungsgemäßen Zusammensetzung, die auf einem Substrat aus Glas oder Keramik angeordnet ist, sehr gut geeignet. Es ist dabei eine extrem hoch auflösende und rückstandsfreie Strukturierung im µm-Bereich der auf Glas- oder Keramikplatten aufgebrachten dünnen Zinnoxid-Schichten möglich. Der Einsatz des Excimerlasers zur Direktstrukturierung derartiger Beschichtungen erfolgt dabei entweder unter Verwendung einer im Strahlengang angeordneten Maske, deren für die Laserstrahlung durchlässigen Bereiche nach Form und Anordnung mit den abzutragenden Bereichen der Schicht korrespondieren, oder aber mittels eines fokussierten Laserstrahls.

Die Erfindung wird nachfolgend anhand eines Beispiels näher erläutert.

Die erfindungsgemäß eingesetzte Beschichtung wurde nach dem Verfahren der Aerosol-Sprühpyrolyse auf das Substrat aufgebracht. Hierbei wurde eine Sprühlösung pneumatisch mit Hilfe einer kommerziellen Sprüheinrichtung in ein Aerosol zerstäubt. Als Treibgas wurde trockener Stickstoff verwendet. Der mittlere Durchmesser der Aerosoltröpfchen lag dabei im Bereich von einigen µm. Die Sprühdüse wurde mit einer XY-Transporteinrichtung in einem Abstand von 10 cm bis 15 cm senkrecht zu dem waagerecht auf einem Flachofen aufliegenden Glassubstrat bewegt. Der Auftrag erfolgte nach Vorreinigung der Glasscheiben mittels eines an sich bekannten Glasreinigungsmittels. Die Substrate wurden in einem Ofen auf eine Oberflächentemperatur von etwa 550 °C erwärmt. Eine derartige Temperatur erwies sich als besonders vorteilhaft, da die spezifische elektrische Leitfähigkeit der aufgetragenen Schicht mit steigender Temperatur generell deutlich zunahm.

Eine bei dem erfindungsgemäßen Verfahren verwendete Sprühlösung wurde folgendermaßen präpariert: In 100 cm³ n-Butylacetat wurden zunächst 20 cm³ Zinnchlorid SnCl₄ gelöst. Nachfolgend wurden 2,10 g Antimonchlorid SbCl₃ sowie 1,14 g Indiumchlorid InCl₃ als Dotierstoffe gelöst.

Die im Lösungsmittel enthaltenen Chloride werden an der heißen Substratoberfläche beim Auftrag hauptsächlich mittels Hydrolyse in einen Oxidfilm mit der erfindungsgemäßen Zusammensetzung Sn_{0,919}Sb_{0,052}In_{0,029}O₂ umgesetzt. Es wurden dabei Zinnoxid-Filmdicken von 140 nm bis 400 nm erhalten.

Eine Borosilikatglasscheibe wurde mit einer dotierten Zinnoxid-Schicht in einer Dicke von 140 nm versehen. Der Flächenwiderstand dieser Schicht betrug 93 Ω. Diese Schicht war weiter charakterisiert durch:
- Kristallstruktur: polykristallin, Cassiterit (Rutil-Struktur)
- Mittlere sichtbare Transmission: > 85 %
- Brechungsindex: 1,95 ± 0,03
- Visuelle optische Qualität: klar, streufrei, frei von Schlieren und Punktdefekten
- Mikroskopisch: Rißfrei unter Vergrößerung 200
- Haftung: Tesa- und Radiergummi-fest
- Chemische Beständigkeit: unlöslich in Wasser, verdünnten Säuren oder Alkalien (insbes. HNO₃, H₂So₄, HCI; NaOH, KOH), kein Angriff in wässr. Salzlösungen (NaCl, KCl), beständig gegen handelsübliche Glasreinigungsmittel, elektrolytisch nur schwer angreifbar in wässr. NaOH/KOH, beständig im Salzsprühtest nach DIN
- Stabilität Flächenwiderstand: An Luft stabil bis mindestens 400 °C, keine Änderung nachweisbar bei Benetzung mit Wasser
- Temperaturbeiwert des Flächenwiderstandes: 3·10⁻⁴ K⁻¹ (bez. auf 20 °C)
- Mikrohärte: Gegenüber Hartglas keine Erhöhung meßbar (Auf Weichglas deutliche Härtung feststellbar)

Die hier beschriebene Zinnoxid-Schicht auf Borosilikatsubstrat wurde nun mit Hilfe eines Excimer-Lasersystems strukturiert, um einen Benetzungssensor, hier einen Pkw-Wisch-Wasch-Sensor, herzustellen.

Der lasergestützte Strukturierungsprozeß ist bevorzugt gekennzeichnet durch den Einsatz eines Excimerlasers, in Verbindung mit einer Maskenprojektion. Die zum Einsatz gekommenen Lasersysteme wiesen folgende technischen Daten auf:

| | |
|---|---|
| Lasertyp | KrF - Excimerlaser |
| Wellenlänge | 248 nm |
| Pulsdauer | 3 bis 25 ns |
| max. Pulsenergie | 460 mJ |
| mittl. Leistung | 70 W |
| Pulsspitzenleistung | > 18 MW |
| Repetitionsrate | 200 Hz |
| Divergenz | 2 x 3 mrad |
| Strahlquerschnitt | (7-10) x 20 mm² |
| Energiestabilität | +/-4 % |

Alternativ ist der Einsatz eines Excimerlasers in Verbindung mit einer Fokussiereinrichtung möglich. Eine derartige Anlagentechnik hat den Vorteil einer sehr flexiblen Strukturierung. Grundsätzlich ist sowohl die Maskenprojektionstechnik, als auch die fokussierte Bearbeitung mittels eines Excimerlasers möglich. Diese Techniken sind an sich bekannt. Das gilt auch für den möglichen Einsatz eines Spiegelablenksystems.

Der Materialabtrag der Zinnoxid-Schichten mittels eines Excimerlasers gestaltete sich problemfrei. Insbesondere wurden überraschenderweise keinerlei Niederschläge des verdampften Schichtmaterials im Isolierkanal beobachtet, so daß feinste Strukturen erzeugbar und keinerlei Nachbearbeitung erforderlich war. Innerhalb der Isolationskanäle wurde zusätzlich das Substratmaterial bis zu einer Tiefe von 20 nm abgetragen. Die Isolationskanäle innerhalb des Zinnoxid-Materials zeichnen sich durch nahezu senkrechte Wände und scharfe Sichtkanten aus. Der Flächenwiderstand der erfindungsgemäßen Beschichtung liegt bei ca. 50 Ω bis 150 Ω.

Ein hergestellter Pkw-Wisch-Wasch-Sensor war hinreichend empfindlich, um auch eine partielle Bedeckung mit Nebeltröpfchen zu detektieren. Die Untersuchungen zeigten darüberhinaus eine gute Verschleißfestigkeit gegen trockenen Abrieb, eine ausreichende Beständigkeit gegenüber handelsüblichen Glasreinigungs- und Autowaschmitteln, sowie eine ausreichende Standzeit in den durch die Autoindustrie vorgegebenen salzsprüh-, umweltbelastungs- und galvanischen Tests.

Ergänzend wurde festgestellt, daß der spezifische elektrische Widerstand der in einer Stärke von 140 nm auf Borosilikatglas angeordneten Zinnoxid-Schicht noch geringfügig zugenommen hatte. Dieses ist z. T. auf die mit zunehmender Schichtdicke etwas ansteigenden Korngrößen des polykristallinen Schichtgefüges zurückzuführen. So wurde bei einer Schicht mit einer Dicke von 360 nm ein Flächenwiderstand von 30 Ω gemessen, anstelle der zu erwartenden 36 Ω.

In Hinblick auf die Tatsache, daß Verbundglasscheiben von Pkw-Frontscheiben auf der Basis von Natron-Kalk-Glas (Weichglas) hergestellt werden, lag der Erfindung insbesondere auch die Aufgabe zugrunde, den oben beschriebenen Sensor auf Weichglas-Substrat zu realisieren. Die erfolgreiche Realisierung des Sensors auf Weichglas-Substrat wird im folgenden als weiteres Ausführungsbeispiel der Erfindung erläutert. Da lediglich der Beschichtungsprozeß hier einer Anpassung bedarf, werden nur die Substrat-spezifischen Unterschiede bei der Beschichtung erläutert.

Weichglas besitzt gegenüber Hartglas u. a. einen wesentlich höheren Gehalt an Alkalioxid, insbesondere an Na₂O. Ab Temperaturen von oberhalb 450 °C diffundiert bekanntermaßen Natrium als kleines lon in erheblichem Maße an die Weichglasoberfläche. Wird nun bei einer Oberflächentemperatur von 500 °C bis 550 °C eine Zinnoxid-Beschichtung vorgenommen, so bildet sich eine Natrium-haltige Zwischenschicht, die durch die Eigenschaft des Natriums, freie Elektronen in Zinnoxid zu binden, einen hohen spezifischen elektrischen Widerstand aufweist. Bei niedrigen Beschichtungsraten wird somit eine Natrium-haltige Zinnoxid-Schicht gebildet, was bei Schichtdicken im Bereich von 100 nm zu Flächenwiderständen im MΩ-Bereich führen kann. Die Existenz solcher Übertragungsschichten wurde spektralphotometrisch nachgewiesen.

Wird jedoch z. B. bei einer Beschichtungsdauer von 7 min. eine hohe Beschichtungsrate von ca. 52 nm/min. gewählt, so wird eine niederohmige, 360 nm dicke Schicht mit einem Flächenwiderstand von (128 ± 6) Ω erhalten. Die Beschichtung erfolgte hier bei einer Beschichtungstemperatur von 500 °C. Mit Hilfe dieser Schicht konnte ein sehr effektiv arbeitender Sensor für Pkw-Frontscheiben realisiert werden. Um zu vermeiden, daß thermomechanisch bedingte Spannungen zum Bruch der zu beschichtenden Scheiben führen, erscheint es im übrigen vorteilhaft, das Aufbringen der Beschichtung in der Glasindustrie sofort in der Abkühlphase der Floatglasherstellung vorzunehmen. Das problematische Aufheizen der Weichglasscheiben kann so vermieden werden.

Grundsätzlich ist der Einsatzbereich der Erfindung keineswegs auf Feuchtigkeitssensoren beschränkt. So ist es auch möglich, Leitbahnen für elektronische Schaltungen herzustellen. Gegebenenfalls ist es dann auch möglich, zusätzlich eine galvanische oder auch reduktive Beschichtung der erfindungsgemäßen Zinnoxid-Schicht mit Leiterwerkstoffen, wie Kupfer, Gold, Platin, o. a., vorzunehmen. Für Leiterbahnen von elektronischen Schaltungen kann eine derartige Verstärkung zur Reduzierung des Bahnwiderstandes vorteilhaft sein. Die bei der erfindungsgemäßen Beschichtung vorhandenen n-leitenden Zinnoxid-Schichten bilden mit diesen Metallen ohmsche Kontakte mit geringem Widerstand. Außerdem ist hier die Verwendung von Quarzglas mit seinen geringen dielektrischen Verlusten als Substrat zum Aufbau von Leiterbahnstrukturen für Hochfrequenz-Schaltungen vorteilhaft. Generell bilden die die erfindungsgemäßen Beschichtung bildenden Zinnoxid-Schichten einen sehr stabilen Verbund mit allen hier genannten Substraten, da eine feste chemische Bindung an den jeweiligen Oberflächen erfolgt.

Eine weitere vorteilhafte Ausgestaltung der Erfindung besteht in der Erzeugung von Strukturen auf Weichglas und Hartgläsern für Display-Anwendungen. Hierbei dient strukturiertes Zinnoxid als transparente Elektrodenstruktur für Flüssigkeitskristall-Filme (LCD). Weiterhin ist auch die Anwendung in anderen elektrostatisch gesteuerten Displays möglich. Letztlich ist auch eine Anwendung der beschriebenen strukturierten Zinnoxid-Schicht als strukturiertes Heizelement möglich. Weitere sensorische Anwendungen sind neben Feuchtigkeitssensoren z. B. auch mikrostrukturierte Gassensoren. Bei diesen Gassensoren müssen zwecks Erzielung von Selektivität für bestimmte Gase die einzelnen Zellen unterschiedlich geheizt werden.

## Patentansprüche

1. Beschichtung zur strukturierten Erzeugung von Leiterbahnen mittels Laser-Strahlung auf der Oberfläche von elektrisch isolierenden Substraten, insbesondere zur Herstellung von Sensorelementen und Leiterplatten, wobei die Beschichtung von einer dotierten Zinnoxid-Schicht mit der Zusammensetzung Sn_{1-(y+z)} A_{y} B_{z} O₂ mit A = Sb oder F und B = In oder Al gebildet ist, dadurch gekennzeichnet, daß der Gehalt der Beschichtung an den Dotierstoffen Antimon oder Fluor zu Indium oder Aluminium durch die Grenzen 0,02 < y + z < 0,11 gegeben ist und das Verhältnis der Dotierstoffe der Bedingung 1,4 < y/z < 2,2 genügt.

2. Beschichtung nach Anspruch 1, dadurch gekennzeichnet, daß die Beschichtung die Zusammensetzung
Sn_{0,919}Sb_{0,052}In_{0,029}O₂
aufweist.

3. Beschichtung nach den Ansprüchen 1 oder 2, dadurch gekennzeichnet, daß die Dicke der Beschichtung zwischen 50 nm und 500 nm liegt.

4. Beschichtung nach wenigstens einem der vorhergehenden Ansprüche, dadurch gekennzeichnet, daß das Substrat aus Quarzglas, Glaskeramik, Hartglas, insbesondere Borosilikat-Hartglas, Weichglas, Aluminiumoxid-Keramik oder Halbleitersilizium besteht.

5. Verfahren zum Herstellen einer Beschichtung nach Anspruch 1, dadurch gekennzeichnet, daß die Beschichtung auf das Substrat bei einer Oberflächentemperatur von 400 °C bis 600 °C mittels eines Aerosol-Sprühpyrolyse-Verfahrens in einer Dicke zwischen 50 nm und 500 nm aufgetragen wird.

6. Verfahren nach Anspruch 5, dadurch gekennzeichnet, daß die Beschichtung auf das Substrat in der Abkühlphase während dessen Herstellung aufgebracht wird.

7. Verfahren zum Herstellen von strukturierten Leiterbahnen unter Verwendung der Beschichtung nach einem der Ansprüche 1 bis 4, dadurch gekennzeichnet, daß die Strukturierung der Beschichtung durch Abtrag mittels elektromagnetischer Laser-Strahlung im Wellenlängenbereich von 157 nm bis 308 nm erfolgt.

8. Verfahren nach Anspruch 7, dadurch gekennzeichnet, daß die Strukturierung der Beschichtung durch Abtrag mittels eines Krypton-Fluorid-Excimerlasers mit einer Wellenlänge von 248 nm erfolgt.

## Claims

1. A coating for the structured production of conductor tracks on the surface of insulating substrates, using laser radiation, especially for the production of sensor elements and circuit boards, whereby the coating is formed from a dosed tin-oxide layer with the composition Sn_{1-(y+z)} A_{y} B_{z} O₂ with A = Sb or F and B = In or Al, characterised in that the content of the coating of the antimony or fluorine to indium or aluminium dosing elements is given by the limits 0.02 < y + z < 0.11 and the ratio of the dosing material satisfies the condition 1.4 < y/z < 2.2.

2. A coating according to Claim 1, characterised in that the coating has the composition
Sn_{0.919}Sb_{0.052}In_{0.029}O₂

3. A coating according to Claim 1 or Claim 2, characterised in that the thickness of the coating lies between 50 nm and 500 nm.

4. A coating according to at least one of the foregoing Claims, characterised in that the substrate comprises quartz glass, glass ceramic, hardened glass, especially borosilicate hard glass, soft glass, aluminium oxide ceramic or silicon semiconductor.

5. A process for manufacturing a coating according to Claim 1, characterised in that the coating is applied to the substrate at a surface temperature of 400°C to 600°C by means of an aerosol-spray pyrolitic process to a thickness of between 50 nm and 500 nm.

6. A process according to Claim 5, characterised in that the coating is applied to the substrate during the cooling phase of its production.

7. A process for the production of structured conductor tracks using the coating according to one of the Claims 1 to 4, characterised in that the structuring of the coating is effected by removal using electromagnetic laser radiation in the wavelength range of 157 nm to 308 nm.

8. A process according to Claim 7, characterised in that the structuring of the coating is effected by erosion using a krypton-fluoride excimer laser with a wavelength of 248 nm.

## Revendications

1. Revêtement pour la production structurée de chemins conducteurs à l'aide d'un rayonnement laser à la surface de substrats électriquement isolants, en particulier pour la fabrication d'éléments capteurs et de circuits imprimés, le revêtement étant constitué d'une couche d'oxyde d'étain dopée présentant la composition Sn_{1-(y+z}) A_{y} B_{z} O₂ avec A = Sb ou F et B = In ou Al, caractérisé en ce que la teneur du revêtement en dopants tels que l'antimoine ou le fluor par rapport à l'indium ou l'aluminium est donnée par les limites 0,02 < y + z < 0,11 et que le rapport des dopants satisfait à la condition 1,4 < y/z < 2,2.

2. Revêtement selon la revendication 1, caractérisé en ce que le revêtement présente la composition
Sn_{0,919}Sb_{0,052}In_{0,029}O₂.

3. Revêtement selon la revendication 1 ou la revendication 2, caractérisé en ce que l'épaisseur du revêtement se situe entre 50 nm et 500 nm.

4. Revêtement selon au moins l'une quelconque des revendications précédentes, caractérisé en ce que le substrat est en verre quartzeux, en vitrocéramique, en verre dur, en particulier en verre dur au borosilicate, en verre tendre, en céramique d'oxyde d'aluminium ou en silicium semi-conducteur.

5. Procédé pour réaliser un revêtement selon la revendication 1, caractérisé en ce que le revêtement est appliqué en une épaisseur de 50 nm à 500 nm sur le substrat, à une température de surface de 400°C à 600°C, à l'aide d'un procédé de pyrolyse par pulvérisation en aérosol.

6. Procédé selon la revendication 5, caractérisé en ce que le revêtement est appliqué sur le substrat durant la phase de refroidissement, pendant la réalisation de ce dernier.

7. Procédé pour réaliser des chemins conducteurs structurés en utilisant le revêtement selon l'une quelconque des revendications 1 à 4, caractérisé en ce que la structuration du revêtement est réalisée par enlèvement à l'aide d'un rayonnement laser électromagnétique dans la gamme de longueurs d'ondes située entre 157 nm et 308 nm.

8. Procédé selon la revendication 7, caractérisé en ce que la structuration du revêtement est réalisée par enlèvement à l'aide d'un laser à excimères au fluorure de krypton avec une longueur d'onde de 248 nm.
